# EUROPEAN PATENT APPLICATION

(11) **EP 4 657 159 A1**
(43) Date of publication of application: **03.12.2025**
(21) Application number: 24178199.6
(22) Date of filing: 27.05.2024
(51) Int. Cl.: G03F 7/20

(54) **UV EXPOSURE DEVICE WITH FEEDING DRAWER**

(71) Applicant: Esko-Graphics Imaging GmbH, 25524 Itzehoe (DE)
(72) Inventor: SIEVERS, Wolfgang, CH-8105 Regensdorf (CH)
(74) Representative: Jonas, Hans-Hermann

(57) **Abstract**

Apparatus and method for exposing a photosensitive printing plate to radiation, including a plurality of stationary radiation sources with a plurality of LEDs configured to emit actinic radiation. A back side radiation source and a front side radiation source collectively define an irradiation field covering an area at least coextensive with an area of the plate. A moveable holder, transmissive to actinic radiation, is configured to receive and move the printing plate relative to the stationary radiation sources and along a lateral direction in a space between the front and back side radiation sources during exposure of the plate. The apparatus includes an enclosure having reflective side walls configured to guide light emitted by the front and back side radiation sources to provide a radiation intensity at the peripheral edges of the plate within a desired degree of homogeneity as compared to in the interior of the plate.

## Description

### BACKGROUND OF THE INVENTION

Many processes are known in the art for preparing polymer printing plates, such as photopolymer flexographic plates and letterpress printing plates coated with photopolymer material. One known process starts with a plate having an ablatable material thereon, imaging the plate in a digital imager to ablate the ablatable material according to imaging data, and then curing the exposed plate by exposure of the plate to radiation, such as light energy, including but not limited to ultraviolet (UV) light energy.

Various processes for curing the plate on both the imaged side and the back side of the plate by exposure to a functional energy source are known, including methods disclosed in EP Pat. No. 33689949B1, assigned to the assignee of the present application and incorporated by reference for all purposes. Known methods include providing a blanket exposure (such as with fluorescent light tubes that emit UV light), and providing the desired radiation using light emitting diode (LED) technology, such as is described in U.S. Patent No. 8,389,203, also assigned to the assignee of the present application and incorporated by reference. One particularly useful LED arrangement is shown and described in U.S. Pat. No. 8,578,854, also incorporated herein by reference.

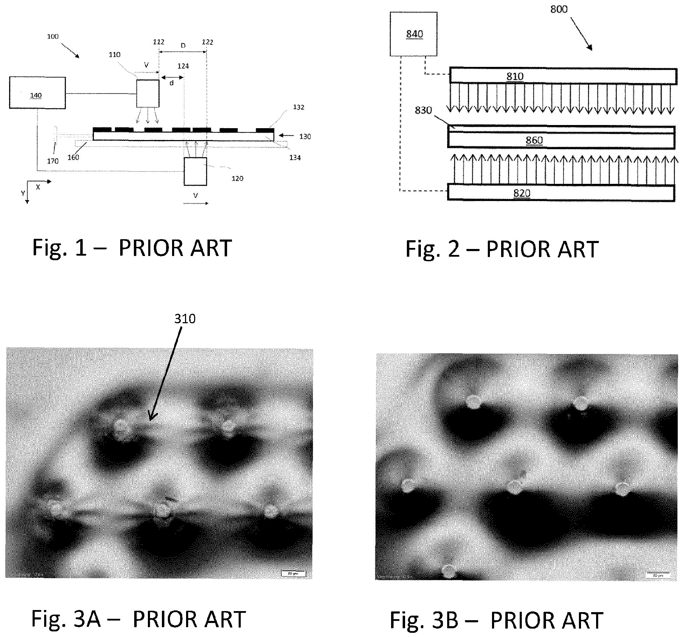

Known processes for curing the plate include means for causing relative movement between the printing plate or substrate and the front and back sources. embodiments in which the front and back radiation sources are fixed or stationary, are illustrated in FIG. 2. In these embodiments (e.g. bank exposure devices), the radiation sources have an irradiation field that is coextensive with an area corresponding to the entirety of plate, which makes it necessary to remove the radiation source positioned above the printing plate, in order to position a printing plate on a surface/holder or remove the printing plate from the surface/holder.

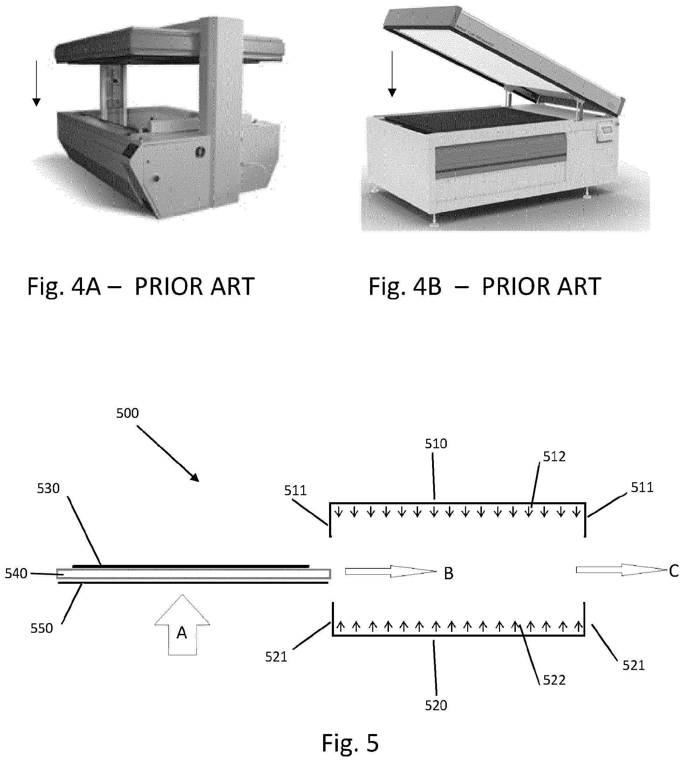

In embodiments in which the printing plate is fixed or stationary, as illustrated in FIG. 1, the means for causing relative movement comprises means for moving the front and back radiation sources relative to the substrate. Moving the radiation sources requires complex and costly mechanic designs, such as the clamshell designs depicted in FIG. 4B or a lifting mechanism design depicted in FIG 4A, where the upper light source 310 is lowered towards the plate along a direction of the arrow. Such solutions are cumbersome and expensive, because they include multiple moving parts that are prone to wear and require maintenance.

Furthermore, such embodiments primarily use fluorescent tubes, but these tubes are often replaced by LED tubes (such as for example the LED replacement-tube called the Shine LEDs provided by Miraclon Corporation of Rochester, NY) as a result of environmental restrictions concerning the use of tubes containing mercury. However, a disadvantage of this workaround is non-optimal placement of the LED light sources, which cause artefacts in the polymer printing dots (e.g. the crow foot effect and non-stable dot support shoulders). The crow foot effect is depicted in detail 310 of FIG. 3A which shows some printing dots on a photopolymer plate that were cured by LED replacement tubes in a conventional bank curing device. In contrast, FIG. 3B shows the same printing dots on a plate cured by a moving LED light source which have broader support shoulders and no crow feet.

Accordingly, there is an incentive to improve conventional curing processes that would reduce the amount of handling to automate the process of loading and unloading a plate as well as improve curing quality of printed dots, without causing relative movement between the front and back radiation sources and the substrate.

### BRIEF DESCRIPTION OF DRAWINGS

FIG. 1 depicts an exemplary apparatus for the exposure of a photosensitive printing plate in accordance with prior art.
FIG. 2 depicts an exemplary apparatus for the exposure of a photosensitive printing plate in accordance with prior art.
FIG. 3A is a photograph of a top view of a dot printed on a substrate in accordance with prior art.
FIG. 3B is a photograph of a top view of another dot printed on a substrate in accordance with prior art.
FIG. 4A is a photograph of an exemplary apparatus for the exposure of a photosensitive printing plate in accordance with prior art.
FIG. 4B is a photograph of an exemplary apparatus for the exposure of a photosensitive printing plate in accordance with prior art.
FIG. 5 is a schematic drawing depicting an apparatus in accordance with an exemplary embodiment of the invention.
FIG. 6 is a schematic drawing depicting another apparatus in accordance with an exemplary embodiment of the invention.
FIG. 7 is a schematic drawing depicting another apparatus in accordance with an exemplary embodiment of the invention.
FIG. 8 is a flowchart depicting an exemplary method of the invention.

### SUMMARY OF THE INVENTION

One aspect of the invention is an apparatus for exposing a printing plate precursor. The printing plate precursor has a photosensitive polymer activated by exposure to actinic radiation. The printing plate precursor has a non-printing back side, a printing front side, peripheral edges, and an interior of the plate defined within the peripheral edges. The apparatus includes a moveable holder, a plurality of radiation sources, and an enclosure. The moveable holder is configured to receive and move the printing plate precursor along a lateral direction in a space between a front side radiation source and a back side radiation source during exposure of the printing plate precursor. The plurality of stationary radiation sources are disposed along a horizontal plane and a distance apart from the moveable holder within the enclosure. The plurality of radiation sources are collectively arranged to expose the front side and the back side of the printing plate precursor to radiation, including the back side radiation source disposed in a lower portion of the apparatus and the front side radiation source disposed in an upper portion of the apparatus. The front side radiation source and the back side radiation source collectively define an irradiation field covering an area at least coextensive with an area of the moveable holder for receiving the printing plate precursor. The front side radiation source and the back side radiation source each have a plurality of light emitting diodes (LEDs) configured to emit actinic ultraviolet (UV) radiation. The enclosure includes reflective side walls configured to guide light emitted by the front side radiation source and the back side radiation source to provide a radiation intensity at the peripheral edges of the printing plate precursor within a desired degree of homogeneity as compared to a radiation intensity in the interior of the printing plate precursor.

Another aspect of this invention is a method for exposing a printing plate precursor. The printing plate precursor includes a photosensitive polymer activated by exposure to radiation. The printing plate has a non-printing back side and a printing front side. The method includes the steps of: providing an apparatus with a printing plate precursor disposed on the moveable holder; controlling a plurality of stationary radiation sources to emit actinic UV radiation; and exposing the printing plate to actinic radiation by moving the moveable holder on which the printing plate precursor is disposed, along a lateral direction in a space between the front side radiation source and back side radiation source for exposure of the printing plate.

### DETAILED DESCRIPTION OF THE INVENTION

An exemplary apparatus 500 for the exposure of photosensitive printing plate 530 is shown schematically in FIG. 5. As is well known in the art, printing plate (or printing plate precursor) 530 comprises a photosensitive polymer activated by exposure to radiation. Further, the printing plate 530 has a non-printing back side, a printing front side, peripheral edges, and an interior of the plate defined within the peripheral edges. A moveable holder 540 is provided and the plate 530 is disposed thereon (e.g. the printing plate 530 may lay flat on a horizontal holder 540). In an exemplary embodiment, the moveable holder 540 is transmissive of the actinic radiation. Additionally or optionally, the moveable holder 540 comprises acrylic glass or silica-based float glass. In a non-limiting example, the holder 540 comprises a float glass that has reduced iron content to have optimized UV transmissivity, such as BOROFLOAT^{®} 33 designed by the SCHOTT Group. Alternatively, the holder 540 comprises acrylic glass such as that used in tanning banks which has low absorption for UV light.

When the plate 530 is disposed on the holder 540, the non-printing back side is in contact with a surface of the holder 540, and the printing front side is facing away from the surface of the holder 540. In an exemplary embodiment, the printing front side includes a Laser Ablation Mask (LAM) layer on top of the photopolymer plate 530, which defines which portions of the plate 530 is cured or uncured (e.g. cured polymer in the printing plate 530 corresponding to areas of the plate 530 exposed and uncured polymer corresponding to areas of the plate 530 not exposed).

In apparatus 500, an enclosure, such as an exposure cabinet, includes an upper portion and a lower portion each having a source of actinic radiation. The enclosure includes side walls having optics (e.g. mirrors 511, 521 discussed below) or coating configured to reflect light emitted by the plurality of radiation sources 510, 520. This configuration provides desired and improved homogeneity of the curing light and compensates for small differences in output of the plurality of LEDs 512, 522 (discussed below). Thus, the enclosure includes reflective side walls configured to guide light emitted by the front side radiation source 510 and the back side radiation source 520 to provide a radiation intensity at the peripheral edges of the printing plate precursor 530 within a desired degree of homogeneity as compared to a radiation intensity in the interior of the printing plate precursor 530.

Generally, the plurality of stationary radiation sources 510, 520 comprises a plurality of individual subsources (not shown), such as fluorescent tubes, LED replacement tubes or LED point sources that are individually controllable or controllable in subsets smaller than the overall irradiation field. The plurality of subsources may be coordinated and controlled to act as a single source, or individually activated in a desired pattern. The radiation sources 510, 520 are connected to a power source. In an exemplary embodiment, the source of actinic radiation includes a back side radiation source 520, which includes a plurality of LEDs 522 configured to emit actinic UV radiation, and a front side radiation source 510, which also includes a plurality of LEDs 512 configured to emit actinic UV radiation. In one non-limiting example, the plurality of LEDs 512, 522 are mounted on electronic circuit boards. Specifically, the plurality of LEDs 522 of the back side radiation source 520 is mounted on a non-reflective or light absorbing circuit boards, thereby reducing reflection of light emitted from the front side radiation source 510. In this configuration, shield 550 is optional.

The plurality of stationary radiation sources 510, 520 are disposed along a horizontal plane and a distance apart from the printing plate 530. Additionally or optionally, the front side radiation source 510 and the back side radiation source 520 each comprise a plurality of LEDs 512, 522 configured to emit radiation in a UVA spectral range. In one non-limiting example, the plurality of LEDS 512, 522 are implemented in a combination of fluorescent tubes and LEDs. Further, the front side radiation source 510 comprises a plurality of LEDs 512 is configured to emit radiation in a UVA spectral range, radiation in a UVC spectral range, or a combination thereof. In this configuration, the UVC LEDs will allow an additional detacking step to be performed with the apparatus 500. Detacking is required for some types of plates 530 as the last processing step to reduce tackiness of the surface of plate 530.

The plurality of radiation sources 510, 520 include the plurality of LEDs 512, 522 which are arranged in a matrix configuration such that the front side radiation source 510 and the back side radiation source 520 collectively define an irradiation field covering an area at least coextensive with an area of the moveable holder 540 for receiving the printing plate precursor 530. Thus, each radiation source 510, 520 may emit a planar radiation field that is at least coextensive with at least the lateral dimensions of at least the plate 530 (e.g. each radiation source 510, 520 may be configured to irradiate the entire plate surface all at once when activated, if configured to be activated in that manner). In this configuration, the distance between the printing plate 530 and the plurality of radiation sources 510, 520 is in a range between 10 to 30 centimeters (cm), or preferably in a range between 15 to 20 cm, in order to achieve the desired irradiation field, such as when an entirety of the plate 530 receives exposure from more than one of the plurality of LEDs and the irradiation field of independent LEDs overlap. In an exemplary embodiment, the plurality of LEDs 512, 522 are each positioned a distance from the polymer plate 530 that would allow sufficient overlap of the irradiation field (e.g. radiation cones) of each of the plurality of LEDs and/ or a fluorescent tube having a plurality of neighboring LEDs. The distance is in a range of 15 to 40 cm when a combination of fluorescent tubes and LEDs are used and 15 to 30 cm if LEDs are exclusively used.

The apparatus 500 may include optics, such as mirrors 511, 521, for directing and/or confining the radiation emitted from the plurality of LEDs 512, 522. The configuration and details of mirrors 511, 521 are disclosed in EP Pat. No. 2124104B1, assigned to the assignee of the present application and incorporated by reference for all purposes. Generally, optics, such as lenses, mirrors and/or other optical hardware components, are configured to direct and/or confine the radiation emitted from the plurality of LEDs 512, 522 to a specific area on printing plate 530. This configuration may produce a stronger contrast between the dark and illuminated areas on printing plate 530, thereby increasing accuracy of the exposure process. In an exemplary embodiment, these mirrors 511, 521 guide the radiation emitted from the plurality of radiation sources towards the photopolymer plate 530, such that the irradiation field is at least coextensive with the area of the moveable holder 540 for receiving the printing plate precursor 530, without experiencing a decay of intensity in the plate's 530 edge regions. Without these mirrors 511, 521, the plurality of radiation sources 510, 520 would need to be much bigger to avoid a decay of radiation intensity in the edge zones of the plate 530. Decay of radiation intensity in the edge zones of the plate may lead to the "crow's feet" effects as discussed in the background section herein above. Further, although illustrated as arrows, one skilled in the art would understand from the description herein that the arrows are not intended to limit the multitude of directions in which light is emitted from the LEDs 512, 522. Additionally or optionally, a shade 550 is provided under the holder 540 to prevent light emitted by from the plurality of LEDs 512 from being reflected and thus additionally contributing to the back side exposure.

The plurality of radiation sources 510, 520 are configured to remain fixed or stationary relative to components of the apparatus, such as at least a holder 540. In this way, moving the plate 530 disposed on the holder 540 avoids the shortcomings of moving the plurality of radiation sources 510, 520 (e.g. need for electrical supply lines and possibly water-cooling lines).

Details regarding irradiance of the plurality of radiation sources 510, 520 is typically a function of the characteristics of the specific type of plate to be exposed, as is known to those of skill in the art, and as is dictated by the manufacturers of such plates. For example, the irradiance may be the same for the front side and the back side, or may be different. Preferably the irradiance at the rear side is only a fraction of the irradiance of the front side exposure. Typically, the irradiance at the rear side is in a range of 10% or less of the front side irradiance, but the invention is not limited to any particular ratio of front to back irradiance.

In an exemplary embodiment of a workflow, the apparatus includes a drive mechanism configured to move at least the holder 540 along a lateral direction and into a space defined between the front side radiation source 510 and back side radiation source 520. The relative movement between the radiation sources 510, 520 and the plate 530 may be provided by any drive mechanism known in the art for moving objects relative to a horizontal, vertical, or otherwise disposed stationary surface. For configurations in which the radiation sources are stationary and the plate is movable, for example, the plate may be mounted on any mechanism known in the art, such as a movable holder 540 configured to move relative to fixed radiation sources. Thus, mechanisms for moving one or more elements relative to another are well known in the art, generally, and the invention is not limited to any particular mechanism.

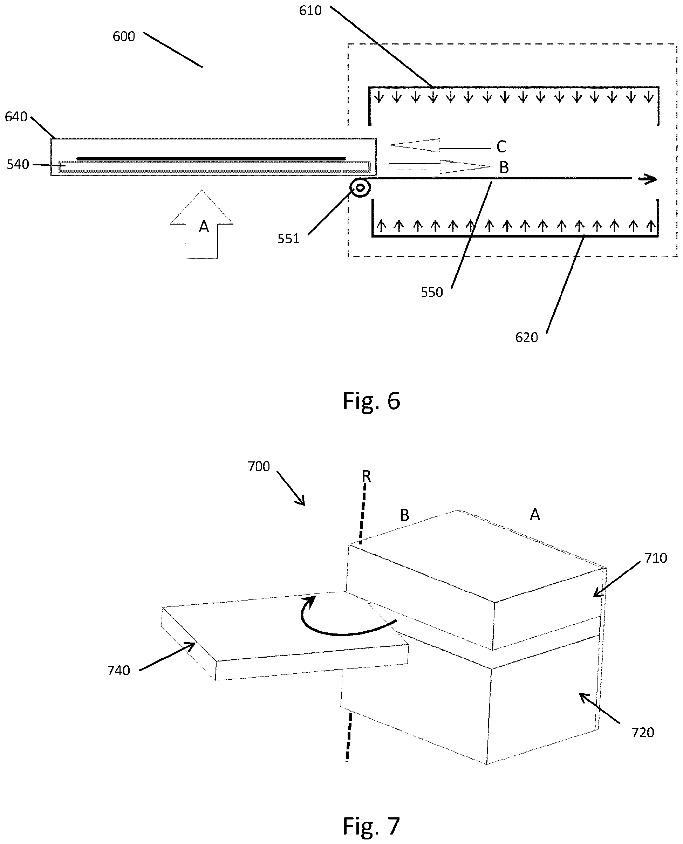

In an exemplary embodiment, the holder 540 is slidably mounted on a frame (e.g. metal frame) by slides or tracks (not shown) slidable between a start or retracted position and an end or extended position. Generally, the plate 530 is movable in at one or two directions to provide the full range of motion required to cover the entire plate 530. The slides or tracks comprise drawer slides, bearing slides, rails, or the like that permit linear movement of at least holder 540. In this way, in a single pass, the printing plate 530 disposed on the holder 540 is configured to move between the start position to an opposite end position along a lateral direction (e.g. to the right as shown in FIG. 5 by arrows B and C ). Additionally or optionally, in a single pass, the printing plate 530 disposed on the holder 540 is configured to move along a lateral direction (e.g. to the right as shown in FIG. 6 by arrow B) from the start position and move along an opposite lateral direction (e.g. in the reverse direction to the left as shown in FIG. 6 by arrow C) toward the end position (e.g. for the next processing step, removal, and/or further handling) without emitting radiation in the return pass. In one embodiment, at least the plate holder 540 or drawer 640 is moved along a lateral direction in one direction (right) and another opposite direction (left) in multiple alternating times, to increase the homogeneity of the curing light. The distance of this movement is just in the range of a few centimeters, just enough to fill the gap between position of the plurality of radiation sources 510, 520. Further, while the exposure step may be performed in a single pass, in some embodiments the exposure may be performed in a plurality of passes, in which each pass imparts radiation at a fraction of the total exposure needed to provide a desired amount of exposure.

In an alternative embodiment, apparatus 700 as depicted in Fig. 7 is generally similar to the details of apparatus 500, 600 as discussed herein, except of certain differences. For example, holder 740 is rotatable about a vertical axis R that is located at one edge of the apparatus 700. The upper front side radiation source 710 and lower back side radiation source 720 are connected at the sides A and B. In operation, at least the holder 740 (upon which plate 530 may be disposed) configured to rotate in and out of a field of exposure to radiation along the rotation axis R.

Generally, an imager may be positioned so that the imaged plate expelled therefrom lands in a first location, and a robotic handling device may be configured to automatically pick up and move the imaged plate from the first location to a processing location, where the exposure process as described herein is then performed. According to an exemplary embodiment, in an automated workflow, a plate handler unloads the plate 530 in step A (shown as arrow A in FIG. 5) from an imager (not shown), e.g. Cyrel^{®} Digital Imager (CDI), and places the plate 530 on the plate holder 540, as described and disclosed in EP Pat. No. 3797035A1, assigned to the assignee of the present application and incorporated by reference for all purposes. The plate holder 540 with the polymer plate 530 thereon is moved along a lateral direction (identified by arrow B in FIG. 5) via drive mechanism into an area of exposure defined by the plurality of radiation sources 510, 520. After a curing step by the back side radiation source 520, the shield 550 is applied under the plate holder 540 prior to a curing step by the front side radiation source 510, in order to avoid additional back side exposure during the front side exposure. In an alternative embodiment, as depicted in FIG. 6, the shield 550 is wound up on a roller 551 when not in use. Further, as described in and disclosed in EP Pat. No. EP3368949A2, which is assigned to the assignee of the present application and incorporated by reference for all purposes, multiple passes may be performed by apparatus 500 such that, back side and front side exposure can each be applied in multiple consecutive exposure steps. After the curing step of the plate 530 is complete, the plate 530 (as shown in arrow C of FIG. 6), is moved out of the exposure cabinet and towards a next processing step (e.g. thermal or solvent processing).

In a non-automated workflow, as depicted in FIG. 6, the apparatus 600 includes the plate holder 540 is integrated into a drawer 640 configured to slide into the exposure cabinet defined by the front side radiation source 610 and back side radiation source 620. The drawer 640 includes the plate holder 540 disposed at a bottom portion thereof and is open toward a top surface and the bottom surface to permit the UV radiation to enter the drawer 640 and cure the plate 530. The operator can open the drawer 640 along the direction C (shown in FIG. 6) in order place the polymer plate 530 inside, close the drawer along the direction B (shown in FIG. 6) and start the exposure or curing process. After the curing or exposure step/process, the operator opens the drawer 640 again, removes the plate 530 and can place the next plate 530 in the drawer 640.

Use of a feeding drawer is known from state-of-the-art UVA aftertreatment devices for polymer plates which are often combined with the drying units that remove the solvent of the washing process from the plates. These devices comprise a drawer to apply aftertreatment with UVA and UVC radiation to the front printing side of the processed plates. One example of such a device is the DuPont Cyrel^{®} 3000D dryer unit. However, in these prior art devices, the radiation is exclusively applied from the top portion of the drawer to the front printing side of the plate 530. The opposite bottom portion of the drawer includes a grid to allow access of heated air to both sides of the plate, but the grid is not suitable for allowing a complete back side exposure of the plate. Thus, unlike prior art devices, the present invention includes a holder 540 on which the plate 530 is disposed and at least back or bottom side of the holder 540 is transmissive of the actinic radiation, and the plates 530 are cured from both the top or upper portion and bottom or lower portion. In one embodiment the curing device is combined with a drying, a post curing and a detacking device. If no separate post curing is available e.g. in a thermal process where no dryer unit is needed, the aftertreatment with UVA and UVC radiation can be executed in the apparatus of the invention.

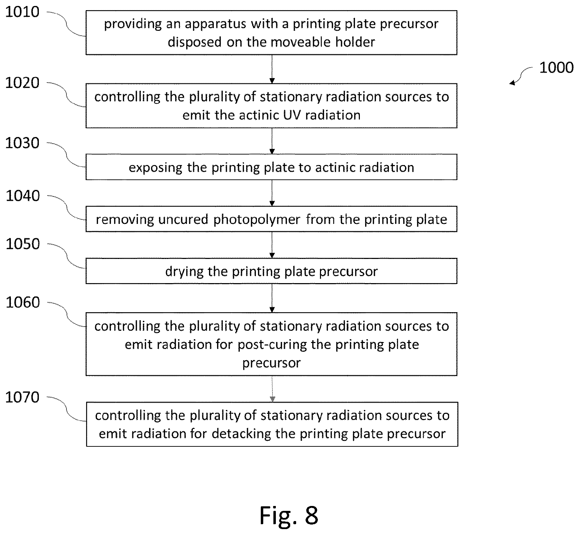

According to another aspect of the invention, as illustrated in FIG. 8, a method 1000 for exposing a printing plate is provided. Details of the method 1000 will be discussed below with reference to the components of apparatus 500, 600, 700 discussed above. The printing plate 530 includes a photosensitive polymer activated by exposure to radiation. The printing plate has a non-printing back side and a printing front side (and optionally, with a mask defining an image to be printed).

The method 1000 includes a step 1010 of providing an apparatus (e.g. apparatus 500, 600, 700 as described herein), a step 1020 of controlling the plurality of stationary radiation sources to emit the actinic UV radiation, and a step 1030 of exposing the printing plate to actinic radiation.

Step 1010 includes providing an apparatus (e.g. apparatus 500, 600, 700) with a printing plate precursor 530 disposed on the moveable holder 540.

Step 1020 includes controlling the plurality of stationary radiation sources. In one embodiment, the plurality of radiation sources 510, 520 are disposed along a horizontal plane and a distance apart from the moveable holder 540 within an enclosure. The plurality of radiation sources 510, 520 are collectively arranged to expose the front side and the back side of the printing plate 530 to radiation. The back side radiation source 520 and a front side radiation source 510 collectively define an irradiation field covering an area at least coextensive with an area of the moveable holder 540 for receiving the printing plate precursor 530. The front side radiation source 510 and the back side radiation source 520 each have a plurality of LEDs 512, 522 configured to emit actinic UV radiation.

Step 1030 includes exposing the printing plate to actinic radiation. In one embodiment, a holder 540 on which the printing plate 530 is disposed is moved along a lateral direction (e.g. from left to right) in a space between the front side radiation source 510 and back side radiation source 520 during exposure of the printing plate precursor 530. In one non-limiting example, the printing plate 530 moves out of a field of exposure (e.g. out of enclosure having the plurality of radiation sources 510, 520) when the holder 540 continues to move along the lateral direction for a distance following completion of step 1030. In another non-limiting example, when exposing the printing plate 530 to actinic radiation comprises exposing the photosensitive polymer through a mask defining an image to be printed, the method 1000 further includes step 1040 pf removing uncured photopolymer from the printing plate 530.

In one embodiment, when the front side radiation source 510 is configured to emit radiation in a UVA spectral range, radiation in a UVC spectral range, or a combination thereof, method 1000 includes a further step of returning the printing plate precursor to the apparatus 500, 600, 700 after completion of step 1040 and performing one or more of: steps 1050 (drying the printing plate precursor 530); step 1060 (controlling the plurality of stationary radiation sources 510, 520 to emit radiation in the UVA spectral range for post-curing the printing plate precursor 530); and step 1070 (controlling the plurality of stationary radiation sources 510, 520 to emit radiation in the UVC spectral range for detacking the printing plate precursor 530).

It should be understood that UV light sources may comprise, for example and without limitation, LEDs, arrays of LEDs, fluorescent lights, such as fluorescent tubes, arc discharge lamps, or any other UV light source known in the art. Although described herein in connection with a UV system and referring to "UV light", it should be understood that the technology described herein is not specific to any particular type of radiation wavelength, visible or non-visible, and that the system may utilize any type of actinic radiation or other radiation that is functional to cause the photochemical reaction necessary to cure the type of plate used. Thus, the term "light source" as used herein refers to any type of actinic radiation source. Further, it should be understood that the term "transparent" as used herein may refer to any material that permits a desired amount of radiation at the desired wavelength pass through the selected material. Thus, "transparent" as used herein, may refer to a material that is not visibly transparent or even translucent to the human eye.

It should be understood that as used herein, the term "printing plate" may be used in shorthand for referring to a printing plate that is ready to receive and transfer ink to a substrate in a printing press, as well as to a printing plate "precursor," which may be the more technically correct term for the unfinished plate during the workflow of converting the printing plate precursor from a form in which it has an unimaged LAMs layer and unexposed photopolymer, through the imaging, exposure, uncured polymer removal, and finishing steps that ultimately creates a finished printing plate. One of skill in the art will recognize from the context of the reference thereto as to whether the printing plate is in a precursor form or finished form.

It should also be understood that the invention is not limited to any particular physical embodiment, and that the method of the invention of incorporating moving the plate in a space between the stationary back side and front side exposure may be performed in any system having any physical configuration.

Although the invention is illustrated and described herein with reference to specific embodiments, the invention is not intended to be limited to the details shown. Rather, various modifications may be made in the details within the scope and range of equivalents of the claims and without departing from the invention.

While preferred embodiments of the invention have been shown and described herein, it will be understood that such embodiments are provided by way of example only. Numerous variations, changes and substitutions will occur to those skilled in the art without departing from the spirit of the invention. Accordingly, it is intended that the appended claims cover all such variations as fall within the spirit and scope of the invention.

## Claims

1. An apparatus for exposing a printing plate precursor, the printing plate precursor comprising a photosensitive polymer activated by exposure to actinic radiation, the printing plate precursor having a non-printing back side, a printing front side, peripheral edges, and an interior of the plate defined within the peripheral edges, the apparatus comprising:
a moveable holder configured to receive and move the printing plate precursor along a lateral direction in a space between a front side radiation source and a back side radiation source for exposure of the printing plate precursor;
a plurality of stationary radiation sources disposed along a horizontal plane and a distance apart from the moveable holder within an enclosure, the plurality of radiation sources collectively arranged to expose the front side and the back side of the printing plate precursor to radiation, including the back side radiation source disposed in a lower portion of the apparatus and the front side radiation source disposed in an upper portion of the apparatus, the front side radiation source and the back side radiation source collectively defining an irradiation field covering an area at least coextensive with an area of the moveable holder for receiving the printing plate precursor, the front side radiation source and the back side radiation source each comprising a plurality of light emitting diodes (LEDs) configured to emit actinic ultraviolet (UV) radiation; and
the enclosure having reflective side walls configured to guide light emitted by the front side radiation source and the back side radiation source to provide a radiation intensity at the peripheral edges of the printing plate precursor within a desired degree of homogeneity as compared to a radiation intensity in the interior of the printing plate precursor.

2. The apparatus of claim 1, wherein the front side radiation source and the back side radiation source each comprise a plurality of LEDs configured to emit radiation in a UVA spectral range.

3. The apparatus of claim 1 or 2, wherein the front side radiation source comprises a plurality of LEDs configured to emit radiation in a UVA spectral range, radiation in a UVC spectral range, or a combination thereof.

4. The apparatus of any one of claims 1-3, wherein the distance between the printing plate and the plurality of radiation sources is in a range between 10 to 30 centimeters (cm), optionally in a range between 15 to 25 cm.

5. The apparatus of any of the foregoing claims, wherein the moveable holder is transmissive of the actinic radiation, optionally wherein the moveable holder comprises acrylic glass or silica-based float glass.

6. The apparatus of any of the foregoing claims, further comprising a drive mechanism configured to move at least the holder along a lateral direction in a space between and relative to the stationary front side radiation source and back side radiation source during exposure of the printing plate.

7. The apparatus of claim 6, wherein the drive mechanism comprises tracks, slides, rails or ball bearings to facilitate movement of at least the holder relative to the stationary front side radiation source and back side radiation source.

8. The apparatus of claim 6, wherein at least the holder is configured to rotate in and out of a field of exposure along a rotation axis that is located along an edge of the apparatus.

9. The apparatus of any of the forgoing claims wherein the holder 540 or drawer 640 is moved along a lateral direction in one direction (right) and another opposite direction (left) in multiple alternating times, to increase the homogeneity of the curing light.

10. The apparatus of any of the foregoing claims, wherein in a single pass, the printing plate disposed on the holder is configured to move between a start position to an opposite end position for a distance and along a lateral direction.

11. The apparatus of any of the foregoing claims, wherein in a single pass, the printing plate disposed on the holder is configured to move along a lateral direction from a start position and move along an opposite lateral direction toward the end position.

12. The apparatus of any of the foregoing claims, wherein the apparatus is further configured with a drying unit for drying the printing plate precursor after an uncured removal processing step.

13. A method for exposing a printing plate precursor, the printing plate precursor comprising a photosensitive polymer activated by exposure to radiation, the printing plate having a non-printing back side and a printing front side, the method comprising the steps of:
a) providing the apparatus of any one of claim 1-11 with a printing plate precursor disposed on the moveable holder;
b) controlling the plurality of stationary radiation sources to emit the actinic UV radiation; and
c) exposing the printing plate to actinic radiation by moving the moveable holder on which the printing plate precursor is disposed, along a lateral direction in a space between the front side radiation source and back side radiation source during exposure of the printing plate.

14. The method of claim 12, wherein printing plate moves out of a field of exposure when the holder continues to move along the lateral direction for a distance following completion of step c).

15. The method of claim 13, wherein exposing the printing plate in step c), comprises exposing the photosensitive polymer through a mask defining an image to be printed, the method further comprising the step of:
d) removing uncured photopolymer from the printing plate.

16. The method of claim 14, wherein the front side radiation source is configured to emit radiation in a UVA spectral range, radiation in a UVC spectral range, or a combination thereof, further comprising returning the printing plate precursor to the apparatus after completion of step d) and performing one or more of the steps of:
e) drying the printing plate precursor;
f) controlling the plurality of stationary radiation sources to emit radiation in the UVA spectral range for post-curing the printing plate precursor; and
g) controlling the plurality of stationary radiation sources to emit radiation in the UVC spectral range for detacking the printing plate precursor.
